# EUROPÄISCHE PATENTSCHRIFT

(11) **EP 1 488 368 B1**
(45) Veröffentlichungstag und Bekanntmachung des Hinweises auf die Patenterteilung: **15.02.2006**
(21) Anmeldenummer: 03720190.2
(22) Anmeldetag: 17.03.2003
(51) Int. Cl.: G06K 7/00, G06K 19/07

(54) **VERFAHREN ZUR KODIERUNG EINER SEQUENZ VON DATENBYTES, INSBESONDERE ZUR ÜBERTRAGUNG ÜBER EINE LUFTSCHNITTSTELLE**
METHOD FOR CODING A SEQUENCE OF DATA BYTES, ESPECIALLY FOR TRANSFERRING VIA AN AIR INTERFACE
PROCEDE DE CODAGE D'UNE SEQUENCE D'OCTETS DE DONNEES, EN PARTICULIER EN VUE D'UNE TRANSMISSION PAR L'INTERMEDIAIRE D'UNE INTERFACE HERTZIENNE

(30) Priorität: 28.03.2002 DE 10214113
(43) Veröffentlichungstag der Anmeldung: 22.12.2004
(73) Patentinhaber: SIEMENS AKTIENGESELLSCHAFT, 80333 München (DE)
(72) Erfinder: CUYLEN, Michael, 90513 Zirndorf (DE)
(86) Internationale Anmeldenummer: PCT/DE2003/000854
(87) Internationale Veröffentlichungsnummer: WO 2003/083761

(56) Entgegenhaltungen:
- WO-A-01/43386
- DE-A- 3 530 224
- US-A- 5 748 119
- "ISO/IEC 15693-2" ISO/IEC INTERNATIONAL STANDARD, 1. Mai 2000 (2000-05-01), XP002246636
- "ISO/IEC 14443-2" ISO/IEC INTERNATIONAL STANDARD, 1. Juli 2001 (2001-07-01), XP002246548

## Beschreibung

Die Erfindung bezieht sich auf die Kodierung einer Sequenz von Datenbytes, wobei jeweils zwei Bit eines Datenbytes ein Doppelbit bilden und jedes Doppelbit durch einen Zeitschlitzrahmen mit zumindest vier Zeitschlitzen repräsentiert wird, welche einen Ein- oder Auswert annehmen können. Die Erfindung bezieht sich weiterhin auf einen mobilen Datenspeicher sowie auf ein Schreib-/Lesegerät zur Durchführung des Verfahrens, sowie auf Identifikationssystem mit dem Schreib-/Lesegerät und mindestens einem mobilen Datenspeicher.

Kontaktlose Identsysteme arbeiten auf Basis von berührungslosen Übertragungstechniken. Diese können z.B. auf elektromagnetische Weise, mittels Infrarot oder Ultraschall beruhen. Derartige Systeme werden beispielsweise zur Identifikation von Personen oder von bewegten Gütern, wie z.B. von Transportmitteln eingesetzt. Die notwendigen Daten werden dazu von einem Schreib-/Lesegerät über eine berührungslose Datenübertragungsstrecke übertragen, wie z.B. über eine Luftschnittstelle zu einem mobilen Datenspeicher und zurück. Die berührungslose Identtechnik gestattet auch die Erfassung der Daten z.B. während einer Vorbeibewegung des mobilen Datenspeichers.

Damit die mobilen Datenspeicher zeitlich unbegrenzt eingesetzt werden können, wird bei diesen auf die Integration von Energiespeichern, wie z.B. Batterien, verzichtet. Die notwendige elektrische Energie wird dabei extern, d.h. einem vom Schreib-/Lesegerät stammenden elektrischen oder magnetischen Feld, kontaktlos entnommen. Dabei ist mit abnehmenden Abstand zwischen Schreib-/Lesegerät und mobilen Datenspeicher zunehmend mehr Energie dem externen Feld entnehmbar.

Zur Kommunikation eines Schreib-/Lesegerät mit derartigen mobilen Datenspeichern sind daher geeignete Übertragungs- und Kodierungsverfahren notwendig, welche sowohl eine energetische Versorgung der Elektronik auf dem mobilen Datenspeicher als auch die Einhaltung von funktechnischen Auflagen sicherstellen. Zudem sind zur Übertragung von Daten i.d.R. nur bestimmte Frequenzbänder freigegeben, wie z.B. die ISM-Frequenzbänder (Industrial, Scientifc & Medical) für industrielle, wissenschaftliche und medizinische Anwendungen.

Solche Verfahren sind z.B. nach der Norm ISO/IEC 15693 Part 2 "Air Interface and Initialization" oder nach der Norm ISO/IEC 14443 als Zeitschlitzverfahren zum Betrieb in einem ISM-Frequenzband bekannt.

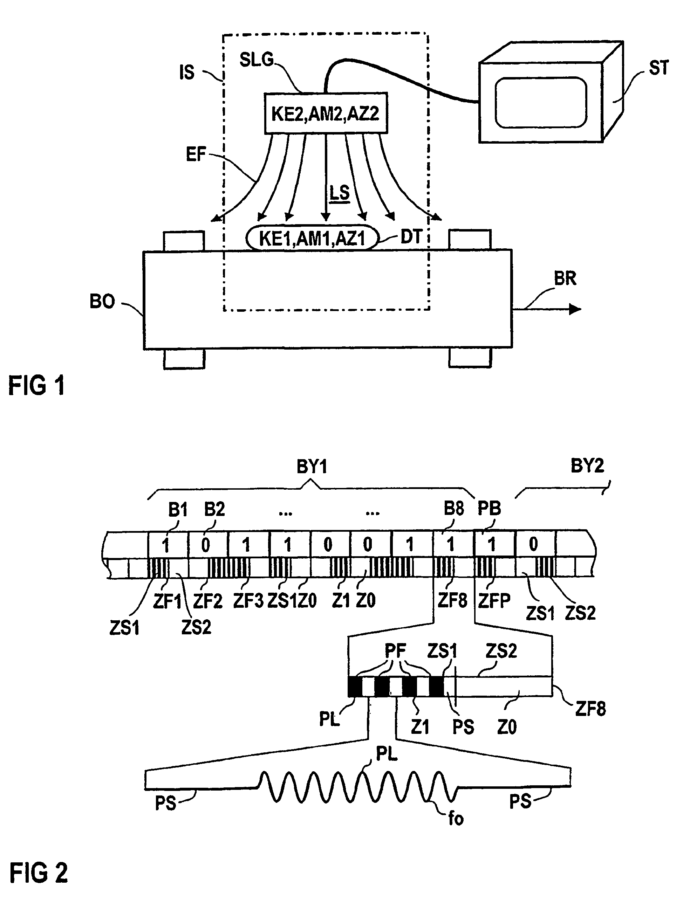

Verfahren dieser Art erlauben eine durchgehende Energieversorgung der Datenspeicherelektronik, indem zur Energieübertragung die mit den zu sendenden Daten modulierte Trägerfrequenz nur für ein maximales Zeitintervall ausgeschaltet wird. Innerhalb dieser Zeit muss ein zuvor im mobilen Datenspeicher aufgeladener Energiespeicher die Energieversorgung überbrücken können. Umgekehrt erfolgt die Datenübertragung vom mobilen Datenspeicher zum Schreib-/Lesegerät mittels einer Belastungsmodulation. Dabei bedämpft der mobile Datenspeicher das induzierende magnetische Feld in kurzen Intervallen. In dieser Belastungsphase benötigt der mobile Datenspeicher die maximale Leistung aus dem zuvor geladenen Energiespeicher. Diese Belastungsphase ist daher so kurz wie möglich zu gestalten, da diese direkten Einfluss auf den maximal möglichen Abstand zwischen Schreib-/Lesegerät und mobilen Datenspeicher für ein schnelles Nachladen hat. Die Belastungsmodulation kann entsprechend der obigen Norm für einen Zeitschlitz als maximales Zeitintervall kontinuierlich erfolgen. Alternativ können Zeitschlitze auch mit einem Hilfsträger trägerfrequenzmoduliert sein, so dass innerhalb eines modulierten Zeitschlitzes Energie übertragen werden kann. Derartige modulierte Zeitschlitze können daher auch direkt aufeinander folgen (siehe dazu auch Figur 2).

Die Norm legt zudem bei einer bestimmten Trägerfrequenz die Feldstärkegrenzwerte für die durch Modulation hervorgerufenen Seitenbänder fest. Für die Höhe der Seitenbandmodulation ist vor allem das Zeitverhältnis sowie die Anzahl der Wechsel von modulierten zu nicht modulierten Zeitschlitzen maßgeblich. Die Beschränkung der maximal zulässigen Feldstärke in den jeweiligen Frequenzbänder führt dabei zu einer Beschränkung der maximalen Datenrate für einen zuvor festgelegten betriebssicheren Abstand. Dies bedeutet zugleich, dass mit zunehmenden Übertragungsabstand zwischen Schreib-/Lesegerät und mobilen Datenspeicher auch die maximal mögliche Datenrate abnimmt.

Wählt man beispielsweise entsprechend der obigen Norm ISO/IEC 14443 Typ A eine Trägerfrequenzmodulation mit einem Hilfsträger und eine Manchesterkodierung für eine zu übertragende Bitfolge eines Datenbytes, so können je nach Bitfolge zwischen 8 und 16 Wechsel zwischen modulierten und nicht modulierten Zeitschlitzen auftreten. Dies wird später in der Figur 2 noch eingehender beschrieben.

Nachteilig daran ist, dass die hohe Anzahl von Wechseln zwischen modulierten und nicht modulierten Zeitschlitzen zu einer hohen Seitenbandmodulation führt. Für viele Anwendungen ist die daraus resultierende maximal mögliche Datenrate und/oder maximal mögliche Übertragungsabstand zwischen Schreib-/Lesegerät und mobilen Datenspeicher nicht mehr ausreichend.

Der Erfindung liegt somit die Aufgabe zu Grunde, ein neues Kodierungsverfahren vorzuschlagen, das eine höhere Datenrate zur Datenübertragung zwischen Schreib-/Lesegerät und mobilen Datenspeicher und/oder einen größeren Übertragungsabstand ermöglicht. Die Einhaltung der Seitenbandmodulationsgrenzen und die Sicherstellung der Energieversorgung für den mobilen Datenspeicher werden weiterhin gewährleistet.

Die Aufgabe wird gelöst mit einem Verfahren zur Kodierung einer Sequenz von Datenbytes, wobei jeweils zwei Bit eines Datenbytes ein Doppelbit bilden und jedes Doppelbit durch einen Zeitschlitzrahmen mit zumindest vier Zeitschlitzen repräsentiert wird, wobei die Zeitschlitze eines Zeitschlitzrahmens einen Ein- oder Auswert annehmen können. Die Kodierung erfolgt in einem Zeitschlitzrahmen so, dass zumindest ein Zeitschlitz mit einem Auswert an einer Position vorbelegt ist, und die nicht vorbelegten Zeitschlitze zur Bildung eines logischen Wertes eines Doppelbits höchstens einen Zeitschlitz mit einem Einwert aufweisen.

Die Aufgabe wird weiterhin gelöst mit einem mobilen Datenspeicher sowie einem Schreib-/Lesegerät zur Durchführung des Verfahrens. Schließlich wird die Erfindung mit einem Identifikationssystem mit dem Schreib-/Lesegerät und zumindest einem mobilen Datenspeicher gelöst. Vorteilhafte weitere Ausgestaltungen des Verfahrens und der Vorrichtungen sind in den Unteransprüchen enthalten.

Damit ist der Vorteil verbunden, dass bei gleichen betrieblichen Abstand zwischen Schreib-/Lesegerät und mobilen Datenspeicher die maximale Datenrate erhöht werden kann. Weiterhin kann vorteilhaft bei einer vorgegebenen Datenrate der Übertragungsabstand zwischen Schreib-/Lesegerät und mobilem Datenspeicher vergrößert werden.

Die Erfindung wird an Hand der nachfolgenden Figuren näher erläutert. Dabei zeigt
- FIG 1 :: ein Beispiel für ein Identifikationssystem, welches ein Schreib-/Lesegerät und einen mobilen Datenspeicher mit je einer Kodiereinrichtung zur Durchführung des erfindungsgemäßen Verfahrens zum berührungslosen Austausch von Daten aufweist,
- FIG 2 :: ein Beispiel für ein Kodierverfahren eines Datenbytes auf Basis des ISO/IEC-Standards 14443, mit einer Manchesterkodierung und einem Hilfsträger gemäß Typ A der o.g. Norm,
- FIG 3 :: eine beispielhafte Kodiervorschrift zur Kodierung eines Datenbytes in Zeitschlitze von Zeitschlitzrahmen gemäß der Erfindung, wobei die Zeitschlitze einen Ein- oder Auswert annehmen können,
- FIG 4 :: eine beispielhafte Kodiervorschrift für einen Sicherungsrahmen, welcher den Zeitschlitzrahmen zur Sicherung einer Datenübertragung eines Datenbytes folgt, und
- FIG 5 :: einen Ausschnitt der Kodierung eines beispielhaften Datenbytes mit einem Sicherungsrahmen in der Zeitschlitzebene gemäß der Erfindung.

FIG 1 zeigt beispielhaft ein Identifikationssystem IS, welches ein Schreib-/Lesegerät SLG und einen mobilen Datenspeicher DT mit je einer Kodiereinrichtung KE1,KE2 zur Durchführung des erfindungsgemäßen Verfahrens aufweist. Der mobile Datenspeicher DT ist dabei an einem beweglichen Objekt BO angebracht, wie z.B. an einem Transportmittel, welches sich in einer Bewegungsrichtung BR relativ zum Schreib-/Lesegerät SLG bewegt. Im Beispiel der Figur werden Daten über eine berührungslose Datenübertragungsstrecke LS, wie z.B. eine Luftschnittstelle übertragen. Im rechten oberen Teil der Figur ist ein beispielhafter Steuerrechner SR dargestellt, der mit dem Schreib-/Lesegerät SLG über eine Schnittstelle in Verbindung steht. Über diese werden die Daten zwischen Steuerrechner SR und Schreib-/Lesegerät SLG z.B. zur Datenerfassung ausgetauscht. Zudem verfügt der mobile Datenspeicher DT sowie das Schreib-/Lesegerät SLG beispielhaft über Abfragemittel AM1,AM2 für eine gezielten Abbruch einer Datenübertragung. AZ1,AZ2 bezeichnen dabei weiterhin Rechenwerte, welche durch die jeweilige Kodiereinrichtung KE1,KE2 bei einem Datenempfang ermittelt und zwischengespeichert werden.

Über die beispielhafte Luftschnittstelle LS erfolgt zugleich die Versorgung des mobilen Datenspeichers DT mit Energie. Zur Veranschaulichung des Energieflusses von Schreib-/Lesegerät SLG zu mobilem Datenspeicher DT sind Energieflusslinien EF eingezeichnet. Die Träger der notwendigen Energie können dabei beispielsweise elektrische oder magnetische Felder, oder auch vom Schreib-/Lesegerät SL ausgesendetes Infrarot-Licht, sichtbares oder ultraviolettes Licht sein. Weitere mögliche Energieträger sind vom Schreib-/Lesegerät SL stammende Mikrowellen, Ultraschallwellen oder Funkwellen.

FIG 2 zeigt ein Beispiel für ein Kodierverfahren eines Datenbytes BY1,BY2 auf Basis des ISO/IEC-Standards 14443, mit einer Manchesterkodierung und einem Hilfsträger gemäß Typ A der o.g. Norm. Die jeweiligen Bits B1-B8 eines Datenbytes BY1,BY2 werden durch je einen Zeitschlitzblock ZF1-ZF8 repräsentiert, welcher aus je zwei Zeitschlitzen ZS1,ZS2 besteht. Dabei wird ein logischer Einwert 1 eines Bits B1-B8 durch zwei aufeinanderfolgende Zeitschlitze ZS1,ZS2 mit einem Einwert Z1 und einem Auswert Z0 dargestellt. Ein logischer Auswert 0 eines Bits B1-B8 wird durch zwei aufeinanderfolgende Zeitschlitze ZS1,ZS2 mit einem Auswert Z0 und einem Einwert Z1 dargestellt. Zur Sicherung der Datenübertragung folgt den acht Bits B1-B8 des Datenbytes BY1 ein Paritybit PB, welches durch einen Parityzeitschlitzblock ZFP repräsentiert wird. Die beiden Zeitschlitze ZS1,ZS2 des Parityzeitschlitzblock ZFP werden dabei in entsprechender Weise kodiert.

Im Beispiel der Figur 2 ist erkennbar, dass bei der Kodierung der beispielhaften Bitfolge 10110011 des Datenbytes BY1 zwölf Wechsel zwischen modulierten und nicht modulierten Zeitschlitzen auftreten. Diese führen, wie eingangs beschrieben, zu einer nachteiligen hohen Seitenbandmodulation, welche die Datenrate und/oder den Übertragungsabstand beschränken.

Weiterhin ist im unteren Bereich der Figur der Zeitschlitzblock ZF8 vergrößert dargestellt. Es dabei erkennbar, dass der modulierte Zeitschlitz ZS1,Z1 aus einer Pulsfolge PF besteht, welche aus Pulsen PL und Pausen PS gebildet wird. Die Pulse PL werden dabei wiederum aus einer ganzzahligen Anzahl von sinusförmigen Trägerschwingungen fo gebildet. Während dieser Pulsphase benötigt ein mobiler Datenspeicher DT für die Belastungsmodulation maximale Leistung, während in den nicht modulierten Pausen PS Energie im mobilen Datenspeicher DT nachgeladen werden kann.

Wie weiterhin dem Beispiel der Figur 2 zu entnehmen ist, hat die Manchesterkodierung der Zeitschlitzblöcke ZF2,ZF3,ZF6,ZF7 zur Folge, dass zwei Zeitschlitze ZS1,ZS2 mit einem Einwert Z1 aufeinander folgen können. Dadurch ist es nachteilig möglich, dass eine durchgehende Energieversorgung des Datenspeichers DT bei einer kontinuierlichen Belastungsmodulation für die Dauer eines Zeitschlitzes ZS1,ZS2 nicht mehr sichergestellt werden kann.

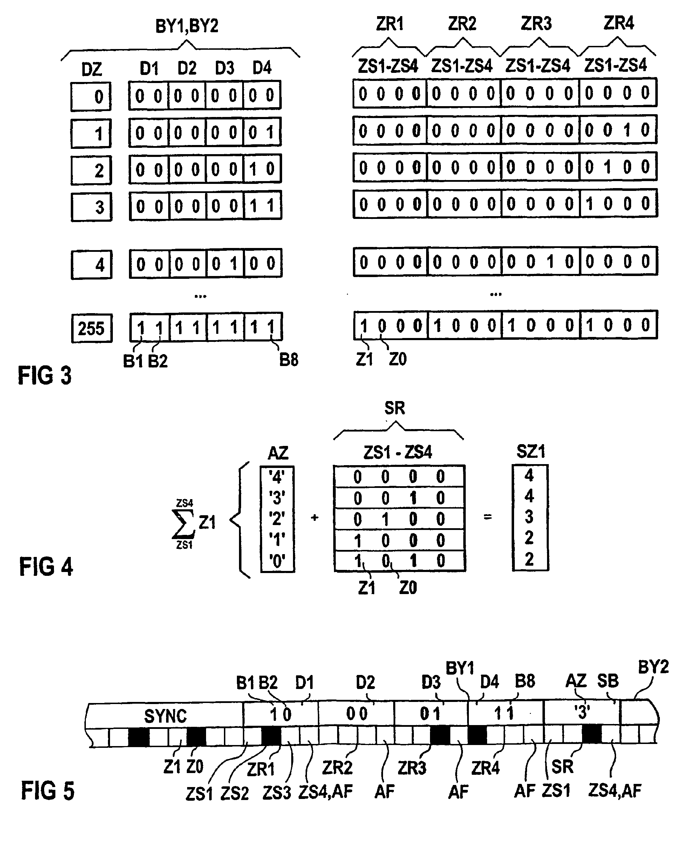

FIG 3 zeigt ein beispielhafte Kodiervorschrift zur Kodierung eines Datenbytes BY1,BY2 in Zeitschlitze ZS1-ZS4 von Zeitschlitzrahmen ZR1-ZR4 gemäß der Erfindung, wobei die Zeitschlitze ZS1-ZS4 einen Ein- oder Auswert Z1,Z0 annehmen können. Im linken Teil der Figur ist beispielhaft die dezimale Darstellung DZ eines Datenbytes BY1,BY2 für die Zahlenwerte 0,1,2,3,4 und 255 sowie die entsprechende binäre Darstellung B1-B8 ersichtlich. Im rechten Teil der Figur ist eine entsprechende beispielhafte Kodierung in den Zeitschlitzrahmen ZR1-ZR4 mit beispielhaft je vier Zeitschlitzen ZS1-Z4 dargestellt.

Erfindungsgemäß bilden jeweils zwei Bit B1,B2 eines Datenbytes BY1,BY2 ein Doppelbit D1-D4, wobei jedes Doppelbit D1-D4 durch einen Zeitschlitzrahmen ZR1-ZR4 mit zumindest vier Zeitschlitzen ZS1-ZS4 repräsentiert wird. Die erfindungsgemäße Kodierung erfolgt in einem Zeitschlitzrahmen ZR1-ZR4 so, dass zumindest ein Zeitschlitz ZS4 mit einem Auswert Z0 an einer Position AF vorbelegt ist, und die nicht vorbelegten Zeitschlitze ZS1-ZS3 zur Bildung eines logischen Wertes 00,01,10,11 eines Doppelbits D1-D4 höchstens einen Zeitschlitz ZS1-ZS3 mit einem Einwert Z1 aufweisen. Im Beispiel der Figur zeigt die Kodierung eines Datenbytes BY1,BY2 mit dem logischen Wert 0 keine Zeitschlitze mit einem Einwert Z1, während die Kodierung des logischen dezimalen Wertes 255 eine maximale Anzahl von vier Zeitschlitzen mit einem Einwert Z1 aufweist. I.Vgl. zur Lösung gemäß dem Beispiel in Figur 2 treten dabei für die Kodierung eines Datenbytes BY1,BY2 maximal vier modulierte Zeitschlitze Z1 auf. Zugleich ist die Anzahl der Wechsel zwischen modulierten und nicht modulierten Zeitschlitzen Z1,Z0 auf einen Wert von acht begrenzt. Weiterhin folgt aufgrund der erfindungsgemäßen Kodierung einem Zeitschlitz ZS1-ZS4 mit einem Einwert Z1 mindestens ein Zeitschlitz ZS1-ZS4 mit einem Auswert Z0.

Damit ist der Vorteil verbunden, dass die Seitenbandmodulation i. Vgl. zur Lösung gemäß FIG 2 erheblich verringert werden kann.

Damit ist der weitere Vorteil verbunden, dass bei gleichen betrieblichen Abstand zwischen Schreib-/Lesegerät SLG und mobilen Datenspeicher DT die maximale Datenrate erhöht werden kann. Weiterhin kann vorteilhaft bei einer vorgegebenen Datenrate der Übertragungsabstand zwischen Schreib-/Lesegerät SLG und mobilem Datenspeicher DT vergrößert werden.

Weiterhin folgt aufgrund der erfindungsgemäßen Kodierung einem Zeitschlitz ZS1-ZS4 mit einem Einwert Z1 mindestens ein Zeitschlitz ZS1-ZS4 mit einem Auswert Z0.

Damit ist der weitere Vorteil verbunden, dass gegenüber der Manchesterkodierung im Beispiel der Figur 2 beide Modulationsverfahren entsprechend der o.g. Normen, d.h. eine kontinuierliche Belastungsmodulation sowie eine Trägerfrequenzmodulation mit einem Hilfsträger, möglich ist.

Dabei kann weiterhin erfindungsgemäß ein Zeitschlitz ZS1-ZS4 mit einem Einwert Z1 durch eine Pulsfolge PF gebildet werden, wobei die Pulsfolge PF eine gerade Anzahl von Pulsen PL und Pausen PS mit einem gleichen Tastverhältnis aufweisen kann. Zudem kann einem Puls PL eine vorgebbare Anzahl von Trägerschwingungen fo, wie im Beispiel der Figur 2 gezeigt, zugeordnet werden.

FIG 4 zeigt eine beispielhafte Kodiervorschrift für einen Sicherungsrahmen SR, welcher den Zeitschlitzrahmen ZR1-ZR4 zur Sicherung einer Datenübertragung eines Datenbytes BY1,BY2 gemäß der Erfindung folgt. Zudem weist der Sicherungsrahmen SR eine den vorangegangenen Zeitschlitzrahmen ZR1-ZR4 entsprechende Anzahl von Zeitschlitzen ZS1-ZS4 auf. Unter einer "entsprechender" Anzahl von Zeitschlitzen ZS1-ZS4 ist dabei eine vorzugsweise gleiche Anzahl für die Zeitschlitzrahmen ZR1-ZR4 und für den Sicherungsrahmen SR zu verstehen. Dabei ist zumindest ein Zeitschlitz ZS1-ZS4 des Sicherungsrahmens SR an der entsprechenden Position AF der Zeitschlitzrahmen ZR1-ZR4 mit einem Auswert Z0 vorbelegt ist. Unter der "entsprechende" Position AF ist ein Zeitschlitz ZS1-ZS4 an einer vorzugsweisen gleichen Position AF sowohl für die Zeitschlitzrahmen ZR1-ZR4 als auch den Sicherungsrahmen SR zu verstehen. Im Beispiel der Figur 4 weist der Sicherungsrahmen SR vier Zeitschlitze ZS1-ZS4 auf, wobei der Zeitschlitz ZS4 an der gleichen Position AF wie im Beispiel der Figur 3 mit einem Auswert Z0 belegt ist.

Erfindungsgemäß erfolgt die Kodierung im Sicherungsrahmen SR so, dass eine erste Einwert-Anzahl AZ aus den Zeitschlitzrahmen ZR1-ZR4 des Datenbyte BY1 in die nicht vorbelegten Zeitschlitze ZS1-ZS4 des Sicherungsrahmens SR mit höchstens zwei nicht aufeinanderfolgenden Einwerten Z1 kodiert wird. Im Beispiel der Figur 4 sind die jeweiligen Werte '0'-'4' der Einwert-Anzahl AZ in Hochkomma dargestellt. Bezogen auf das Beispiel in Figur 3 weist die Kodierung der dezimalen Zahl 255 vier Zeitschlitze ZS1 mit einem Einwert Z1 auf.

Damit ist der Vorteil verbunden, dass ein nach der Datenübertragung in einem Zeitschlitzrahmen ZR1-ZR4 fehlender Einwert Z1 oder eine fehlerhafte Belegung eines ursprünglich nur mit Auswerten Z0 belegten Zeitschlitzrahmens ZR1-ZR4 erkannt werden kann. Dazu wird die im Sicherungsrahmen SR kodierte Einwert-Anzahl AZ mit der tatsächlichen Anzahl der Einwerte Z1 beim Datenempfang verglichen.

Weiterhin wird im Beispiel der Figur die Einwert-Anzahl AZ mit dem Wert '4' wird durch vier Zeitschlitze ZS1-ZS4 mit einem Auswert Z0 im Sicherungsrahmen SR kodiert. Erfindungsgemäß erfolgte dabei die Belegung der Zeitschlitze ZS1-ZS4 des Sicherungsrahmens SR so, dass die Streuung aller Einwert-Summenwerte SZ1 in den Zeitschlitzrahmen ZR1-ZR4 des Datenbytes BY1 und im Sicherungsrahmen SR minimal wird. Für das o.g. Beispiel weist der Einwert-Summenwert SZ1 den Wert 4 auf.

Dadurch sind die Unterschiede zwischen den jeweiligen Einwert-Summenwerten SZ1 untereinander möglichst gering, so dass vorteilhaft eine möglichst gleichmäßige Anzahl von Wechsel zwischen modulierten und nicht modulierten Zeitschlitzen, d.h. zwischen Ein- und Auswerten Z1,Z0 erreicht wird.

Bei der Kodierung des dezimalen Wertes 0 des Datenbytes BY1, BY2 in vier Zeitschlitzrahmen ZR1-ZR4 mit ausschließlichen Auswerten Z0 folgt ein Sicherungsrahmen SR mit der Zeitschlitzbelegung 1010. Dadurch wird vorteilhaft eine Möglichkeit zur 'Aufsynchronisierung' für die bei einem Datenempfang beteiligten Schaltungen nach der langen Folge von Auswerten Z0 erreicht.

FIG 5 zeigt einen Ausschnitt der Kodierung eines beispielhaften Datenbytes mit einem Sicherungsrahmen in der Zeitschlitzebene gemäß der Erfindung. Dabei wird das zu übertragende beispielhafte Datenbyte BY1 aus vier Doppelbit D1-D4 mit den logischen Werten 00,01,10,11 gebildet. Die jeweiligen Doppelbit D1-D4 werden durch einen Zeitschlitzrahmen ZR-ZR4 repräsentiert. Weiterhin folgt den Doppelbit D1-D4 ein Sicherungsblock SB mit dem Wert der Einwert-Anzahl von '3'. Dieser Wert durch den Sicherungsrahmen SR durch vier Zeitschlitze ZS1-ZS4 mit der Belegung 0010 repräsentiert.

Erfindungsgemäß befindet sich die Position AF des vorbelegten Zeitschlitzes ZS1-ZS4 am Anfang oder Ende des Zeitschlitz- oder Sicherungsrahmens ZR1-ZR4,SR. Im Beispiel der Figur 5 ist dies der letzte Zeitschlitz ZS4 eines Zeitschlitz- oder Sicherungsrahmens ZR1-ZR4.

Dadurch ist vorteilhaft bei einem Empfang eine Überprüfung der ersten Zeitschlitze ZS1-ZS3 eines Zeitschlitz- oder Sicherungsrahmens SR auf Richtigkeit möglich. In einem Fehlerfall kann dann der nachfolgende nicht modulierte Zeitschlitz ZS4 zur Anzeige eines vorliegenden Fehlers moduliert werden.

Weiterhin ist in Figur 5 ein Synchronisierungsblock SYNC erkennbar, welcher den kodierten Zeitschlitzrahmen ZR1-ZR4 vorangeht und wiederholende Sequenzen von einem Einwert Z1 und zwei folgenden Auswerten Z0 aufweist.

Dadurch ist vorteilhaft eine einfache gestaltete Synchronisierungsmöglichkeit für die Empfangsschaltungen eines Schreib-/Lesegerät SLG oder eines mobilen Datenspeichers DT.

Ein weiterer Vorteil ist es, dass der Synchronisierungsblock SYNC eindeutig als solcher erkannt werden kann, da die o.g. sich wiederholende Sequenz nicht in die vier Zeitschlitzrahmen und in den Sicherungsrahmen SR kodierbar ist.

Weiterhin kann ein mobiler Datenspeicher DT zum berührungslosen Austausch einer Sequenz von Datenbytes BY1,BY2 mit einem Schreib-/Lesegerät SLG verwendet werden, welcher eine erste Kodiereinrichtung KE1 zur Durchführung des erfindungsgemäßen Verfahrens aufweist. Mittels der ersten Kodiereinrichtung KE1 des mobilen Datenspeichers DT kann bei Empfang zweier aufeinanderfolgender Zeitschlitze ZS1-ZS4 mit einem Einwert Z1 ein Zeitschlitz ZS1-ZS4 an einer Position AF mit einem Einwert Z1 belegt werden. Mittels der ersten Kodiereinrichtung KE1 kann auch erfindungsgemäß eine zweite Einwert-Anzahl AZ1 aus den Zeitschlitzrahmen ZR1-ZR4 eines Datenbytes BY1 ermittelt werden und diese mit einer zuvor in einem Sicherungsrahmen SR kodierten ersten Einwert-Anzahl AZ verglichen werden. Dadurch kann bei einem unterschiedlichem Ergebnis ein Zeitschlitz ZS1-ZS4 des Sicherungsrahmens SR an einer Position AF mit einem Einwert Z1 belegt werden.

Dadurch kann vorteilhaft eine fehlerhafte Übertragung durch die Modulierung Z1 eines Zeitschlitzes ZS1-ZS4 dem Schreib-/Lesegerät SLG mitgeteilt werden.

In entsprechender Weise kann ein Schreib-/Lesegerät SLG zum berührungslosen Austausch einer Sequenz von Datenbytes BY1,BY2 mit zumindest einem mobilen Datenspeicher DT verwendet werden, welches eine zweite Kodiereinrichtung KE2 zur Durchführung des erfindungsgemäßen Verfahrens aufweist. Mittels der zweiten Kodiereinrichtung KE2 des Schreib-/Lesegerät SLG kann bei Empfang zweier aufeinanderfolgender Zeitschlitze ZS1-ZS4 mit einem Einwert Z1 ein Zeitschlitz ZS1-ZS4 an einer Position AF mit einem Einwert Z1 belegt werden. Mittels der zweiten Kodiereinrichtung KE2 kann auch eine dritte Einwert-Anzahl AZ2 aus den Zeitschlitzrahmen ZR1-ZR4 eines Datenbytes BY1 ermittelt werden und diese mit einer zuvor in einem Sicherungsrahmen SR kodierten ersten Einwert-Anzahl AZ verglichen werden. Dadurch kann bei einem unterschiedlichem Ergebnis ein Zeitschlitz ZS1-ZS4 des Sicherungsrahmens SR an einer Position AF mit einem Einwert Z1 belegt werden.

Dadurch kann vorteilhaft eine fehlerhafte Übertragung durch die Modulierung Z1 eines Zeitschlitzes ZS1-ZS4 dem mobilen Datenspeicher DT mitgeteilt werden.

Weiterhin kann ein mobiler Datenspeicher DT Abfragemittel AM1 aufweisen, welche bei Erkennung eines Einwertes Z1 an einer Position AF eines vorbelegten Zeitschlitzes ZS1-ZS4 den berührungslosen Austausch einer Sequenz von Datenbytes BY1,BY2 erfindungsgemäß abbrechen. Der mobile Datenspeicher DT kann dann nach einem Abbruch den berührungslosen Austausch zumindest ab dem nicht ausgetauschten Teil der Sequenz von Datenbytes BY1, BY2 gemäß der Erfindung neu starten.

Ebenso kann ein Schreib-/Lesegerät SLG Abfragemittel AM2 aufweisen, welche erfindungsgemäß bei Erkennung eines Einwertes Z1 an einer Position AF eines vorbelegten Zeitschlitzes ZS1-ZS4 den berührungslosen Austausch einer Sequenz von Datenbytes BY1,BY2 abbrechen. Das Schreib-/Lesegerät SLG kann dann nach einem Abbruch den berührungslosen Austausch zumindest ab dem nicht ausgetauschten Teil der Sequenz von Datenbytes BY1, BY2 gemäß der Erfindung neu starten.

Schließlich kann zur Durchführung des erfindungsgemäßen Verfahrens ein Identifikationssystem IS mit einem Modulationsverfahren auf Basis des ISO/IEC 14443-Standards oder des ISO/IEC 15693-Standards in einem ISM-Frequenzband, insbesondere in einem ISM-Frequenzband von 13,56 MHz betrieben werden. Zudem können in dem Identifikationssystem IS zwischen mindestens einem Schreib-/Lesegerät SLG und mindestens einem mobilen Datenspeicher DT Sequenzen von Datenbytes BY1,BY2 über eine berührungslose Datenübertragungsstrecke LS ausgetauscht werden.

Dies ist insbesondere für eine Luftschnittstelle LS zur Kopplung zwischen Schreib-/Lesegerät SLG und mobilem Datenspeicher DT auf induktivem Wege vorteilhaft.

## Patentansprüche

1. Verfahren zur Kodierung einer Sequenz von Datenbytes (BY1, BY2), wobei jeweils zwei Bit (B1,B2) eines Datenbytes (BY1) ein Doppelbit (D1-D4) bilden und jedes Doppelbit (D1-D4) durch einen Zeitschlitzrahmen (ZR1-ZR4) mit zumindest vier Zeitschlitzen (ZS1-ZS4) repräsentiert werden, welche einen Ein- oder Auswert (Z1,Z0) annehmen können,
**dadurch gekennzeichnet, dass** die Kodierung in einem Zeitschlitzrahmen (ZR1-ZR4) so erfolgt, dass
a) zumindest ein Zeitschlitz (ZS1-ZS4) mit einem Auswert (Z0) an einer festen Position (AF) vorbelegt ist, und
b) die nicht vorbelegten Zeitschlitze (ZS1-ZS4) zur Bildung eines logischen Wertes (00,01,10,11) eines Doppelbits (D1-D4) höchstens einen Zeitschlitz (ZS1-ZS4) mit einem Einwert (Z1) aufweisen.

2. Verfahren nach Anspruch 1, wobei den Zeitschlitzrahmen (ZR1-ZR4) eines Datenbytes (BY1) ein Sicherungsrahmen (SR) folgt, welcher eine den vorangegangenen Zeitschlitzrahmen (ZR1-ZR4) entsprechende Anzahl von Zeitschlitzen (ZS1-ZS4) aufweist, wobei
a) zumindest ein Zeitschlitz (ZS1-ZS4) des Sicherungsrahmens (SR) an der entsprechenden Position (AF) der Zeitschlitzrahmen (ZR1-ZR4) mit einem Auswert (Z0) vorbelegt ist, und
b) die Kodierung im Sicherungsrahmen (SR) so erfolgt, dass eine erste Einwert-Anzahl (AZ) aus den Zeitschlitzrahmen (ZR1-ZR4) des Datenbyte (BY1) in die nicht vorbelegten Zeitschlitze (ZS1-ZS4) des Sicherungsrahmens (SR) mit höchstens zwei nicht aufeinanderfolgenden Einwerten (Z1) kodiert wird.

3. Verfahren nach Anspruch 2, wobei die Zeitschlitze (ZS1-ZS4) des Sicherungsrahmens (SR) so belegt werden, dass die Streuung aller Einwert-Summenwerte (SZ1) in den Zeitschlitzrahmen (ZR1-ZR4) des Datenbytes (BY1) und im Sicherungsrahmen (SR) minimal wird.

4. Verfahren nach einem der vorangegangenen Ansprüche, wobei sich die Position (AF) des vorbelegten Zeitschlitzes (ZS1-ZS4) am Anfang oder Ende des Zeitschlitz- oder Sicherungsrahmens (ZR1-ZR4,SR) befindet.

5. Verfahren nach einem der vorangegangenen Ansprüche, wobei ein Zeitschlitz (ZS1-ZS4) mit einem Einwert (Z1) durch eine Pulsfolge (PF) gebildet wird.

6. Verfahren nach Anspruch 5, wobei die Pulsfolge (PF) eine gerade Anzahl von Pulsen (PL) und Pausen (PS) mit einem gleichen Tastverhältnis aufweist.

7. Verfahren nach Anspruch 6, wobei einem Puls (PL) eine vorgebbare Anzahl von Trägerschwingungen (fo) zugeordnet wird.

8. Mobiler Datenspeicher (DT) zum berührungslosen Austausch einer Sequenz von Datenbytes (BY1,BY2) mit einem Schreib-/Lesegerät (SLG), mit einer ersten Kodiereinrichtung (KE1), welche zur Durchführung des Verfahrens nach einem der vorangegangenen Ansprüche 1 bis 7 eingerichtet ist.

9. Mobiler Datenspeicher (DT) nach Anspruch 8, wobei die erste Kodiereinrichtung (KE1) bei Empfang zweier aufeinanderfolgender Zeitschlitze (ZS1-ZS4) mit einem Einwert (Z1) einen Zeitschlitz (ZS1-ZS4) an einer Position (AF) mit einem Einwert (Z1) belegt.

10. Mobiler Datenspeicher (DT) nach Anspruch 8, wobei die erste Kodiereinrichtung (KE1) eine zweite Einwert-Anzahl (AZ1) aus den Zeitschlitzrahmen (ZR1-ZR4) eines Datenbytes (BY1) ermittelt und diese mit einer zuvor in einem Sicherungsrahmen (SR) kodierten ersten Einwert-Anzahl (AZ) vergleicht, und bei einem unterschiedlichem Ergebnis einen Zeitschlitz (ZS1-ZS4) des Sicherungsrahmens (SR) an einer Position (AF) mit einem Einwert (Z1) belegt.

11. Mobiler Datenspeicher (DT) nach Anspruch 8, mit Abfragemitteln (AM1), welche bei Erkennung eines Einwertes (Z1) an einer Position (AF) eines vorbelegten Zeitschlitzes (ZS1-ZS4) den berührungslosen Austausch einer Sequenz von Datenbytes (BY1,BY2) abbrechen.

12. Mobiler Datenspeicher (DT) nach Anspruch 11, welcher nach einem Abbruch den berührungslosen Austausch zumindest ab dem nicht ausgetauschten Teil der Sequenz von Datenbytes (BY1,BY2) neu startet.

13. Schreib-/Lesegerät (SLG) zum berührungslosen Austausch einer Sequenz von Datenbytes (BY1,BY2) mit zumindest einem mobilen Datenspeicher (DT), mit einer zweiten Kodiereinrichtung (KE2), welche zur Durchführung des Verfahrens nach einem der vorangegangenen Ansprüche 1 bis 7 eingerichtet ist.

14. Schreib-/Lesegerät (SLG) nach Anspruch 13, wobei die zweite Kodiereinrichtung (KE2) bei Empfang zweier aufeinanderfolgender Zeitschlitze (ZS1-ZS4) mit einem Einwert (Z1) einen Zeitschlitz (ZS1-ZS4) an einer Position (AF) mit einem Einwert (Z1) belegt.

15. Schreib-/Lesegerät (SLG) nach Anspruch 13, wobei die zweite Kodiereinrichtung (KE2) eine dritte Einwert-Anzahl (AZ2) aus den Zeitschlitzrahmen (ZR1-ZR4) eines Datenbytes (BY1) ermittelt und diese mit einer zuvor in einem Sicherungsrahmen (SR) kodierten ersten Einwert-Anzahl (AZ) vergleicht, und bei einem unterschiedlichem Ergebnis einen Zeitschlitz (ZS1-ZS4) des Sicherungsrahmens (SR) an einer Position (AF) mit einem Einwert (Z1) belegt.

16. Schreib-/Lesegerät (SLG) nach Anspruch 13 mit Abfragemitteln (AM2), welche bei Erkennung eines Einwertes (Z1) an einer Position (AF) eines vorbelegten Zeitschlitzes (ZS1-ZS4) den berührungslosen Austausch einer Sequenz von Datenbytes (BY1,BY2) abbrechen.

17. Schreib-/Lesegerät (SLG) nach Anspruch 16, welcher nach einem Abbruch den berührungslosen Austausch zumindest ab dem nicht ausgetauschten Teil der Sequenz von Datenbytes (BY1,BY2) neu startet.

18. Identifikationssystem (IS) mit Mitteln zur Durchführung des Verfahrens nach einem der Ansprüche 1 bis 7 mit einem Modulationsverfahren auf Basis des ISO/IEC 14443-Standards zum Betrieb in einem ISM-Frequenzband.

19. Identifikationssystem (IS) mit Mitteln zur Durchführung des Verfahrens nach einem der Ansprüche 1 bis 7 mit einem Modulationsverfahren auf Basis des ISO/IEC 15693-Standards zum Betrieb in einem ISM-Frequenzband.

20. Identifikationssystem (IS) nach Anspruch 18 oder 19, welches in einem ISM-Frequenzband von 13,56 MHz betrieben wird.

21. Identifikationssystem (IS) mit mindestens einem Schreib-/Lesegerät (SLG) nach Anspruch 13 oder 17 und mindestens einem mobilen Datenspeicher (DT) nach einem der Ansprüche 8 bis 12, welche über eine berührungslose Datenübertragungsstrecke (LS) Sequenzen von Datenbytes (BY1,BY2) austauschen.

## Claims

1. Method for coding a sequence of data bytes (BY1,BY2), in which in each case two bits (B1, B2) of a data byte (BY1) form a double bit (D1-D4), and each double bit (D1-D4) is represented by a time slot frame (ZR1-ZR4) having at least four time slots (ZS1-ZS4) which can assume an on or off value (Z1, Z0),
**characterized in that** the coding in a time slot frame (ZR1-ZR4) is carried out such that
a) at least one time slot (ZS1-ZS4) is preloaded with an off value (Z0) at a fixed position (AF), and
b) the time slots (ZS1-ZS4) which have not been preloaded have at most one time slot (ZS1-ZS4) with an on value (Z1) in order to form a logic value (00, 01, 10, 11) of a double bit (D1-D4).

2. Method according to Claim 1, in which a protection frame (SR) follows the time slot frame (ZR1-ZR4) of a data byte (BY1) and has a number of time slots (ZS1-ZS4) corresponding to the previous time slot frames (ZR1-ZR4), in which
a) at least one time slot (ZS1-ZS4) in the protection frame (SR) is preloaded with an off value (Z0) at the corresponding position (AF) in the time slot frames (ZR1-ZR4), and
b) coding in the protection frame (SR) is carried out such that a first on value number (AZ) from the time slot frames (ZR1-ZR4) of the data byte (BY1) is coded with at most two non-successive on values (Z1) in those time slots (ZS1-ZS4) of the protection frame (SR) which have not been preloaded.

3. Method according to Claim 2, in which the time slots (ZS1-ZS4) of the protection frame (SR) are loaded such that the scatter of all the on value sum values (SZ1) in the time slot frame (ZR1-ZR4) of the data byte (BY1) and in the protection frame (SR) is a minimum.

4. Method according to one of the preceding claims, in which the position (AF) of the preloaded time slot (ZS1-ZS4) is located at the start or end of the time slot or protection frame (ZR1-ZR4,SR)

5. Method according to one of the preceding claims, in which a time slot (ZS1-ZS4) with an on value (Z1) is formed by a pulse sequence (PF).

6. Method according to Claim 5, in which the pulse sequence (PF) has an even number of pulses (PL) and pauses (PS) with the same duty ratio.

7. Method according to Claim 6, in which a pulse (PL) has an associated number, which can be predetermined, of carrier oscillations (fo).

8. Mobile data memory (DT) for non-contacting interchange of a sequence of data bytes (BY1,BY2) with a read/write appliance (SLG), having a first coding device (KE1) for carrying out the method according to one of the preceding Claims 1 to 7.

9. Mobile data memory (DT) according to Claim 8, in which, on receiving two successive time slots (ZS1-ZS4) with an on value (Z1), the first coding device (KE1) loads a time slot (ZS1-ZS4) at a position (AF) with an on value (Z1).

10. Mobile data memory (DT) according to Claim 8, in which the first coding device (KE1) determines a second number of on values (AZ1) from the time slot frames (ZR1-ZR4) in a data byte (BY1), and compares this with a first on value number (AZ) which was previously coded in a protection frame (SR), and, if the result is different, loads a time slot (ZS1-ZS4) in the protection frames (SR) with an on value (Z1) at a position (AF).

11. Mobile data memory (DT) according to Claim 8, having checking means (AM1) which interrupt the non-contacting interchange of a sequence of data bytes (BY1,BY2) on identification of an on value (Z1) at a position (AF) in a preloaded time slot (ZS1-ZS4).

12. Mobile data memory (DT) according to Claim 11, which restarts the non-contacting interchange, at least from that part of the sequence of data bytes (BY1,BY2) which has not been interchanged, after an interruption.

13. Read/write appliance (SLG) for non-contacting interchange of a sequence of data bytes (BY1,BY2) having at least one mobile data memory (DT), having a second coding device (KE2) for carrying out the method according to one of the preceding Claims 1 to 7.

14. Read/write appliance (SLG) according to Claim 13, in which, on receiving two successive time slots (ZS1-ZS4) with an on value (Z1), the second coding device (KE2) loads a time slot (ZS1-ZS4) with an on value (Z1) at a position (AF).

15. Read/write appliance (SLG) according to Claim 13, in which the second coding device (KE2) determines a third on value number (AZ2) from the time slot frames (ZR1-ZR4) of a data byte (BY1), and compares this with a first on value number (AZ) which was previously coded in a protection frame (SR), and, if the result is different, loads a time slot (ZS1-ZS4) in the protection frame (SR) with an on value (Z1) at a position (AF).

16. Read/write appliance (SLG) according to Claim 13, having checking means (AM2) which interrupt the non-contacting interchange of a sequence of data bytes (BY1,BY2) on identification of an on value (Z1) at a position (AF) in a preloaded time slot (ZS1-ZS4).

17. Read/write appliance (SLG) according to Claim 16, which restarts the non-contacting interchange, at least from that part of the sequence of data bytes (BY1,BY2) which has not been interchanged, after an interruption.

18. Identification system (IS) having means for carrying out the method according to one of Claims 1 to 7 using a modulation method based on the ISO/IEC 14443 Standard for operation in a ISM frequency band.

19. Identification system (IS) having means for carrying out the method according to one of Claims 1 to 7 using a modulation method based on the ISO/IEC 15693 Standard for operation in a ISM frequency band.

20. Identification system (IS) according to Claim 18 or 19, which is operated in an ISM frequency band of 13.56 MHz.

21. Identification system (IS) having at least one read/write appliance (SLG) according to Claim 13 or 17, and at least one mobile data memory (DT) according to one of Claims 8 to 12, which interchange sequences of data bytes (BY1,BY2) via a non-contacting data transmission path (LS).

## Revendications

1. Procédé de codage d'une séquence d'octets de données (BY1, BY2), respectivement deux bits (B1, B2) d'un octet de données (BY1) formant un double bit (D1 à D4) et chaque double bit (D1 à D4) étant représenté par une trame à créneaux temporels (ZR1 à ZR4) ayant au moins quatre créneaux temporels (ZS1 à ZS4) qui peuvent prendre une valeur un ou une valeur zéro (Z1, Z0),
**caractérisé par le fait que** le codage dans une trame à créneaux temporels (ZR1 à ZR4) s'effectue de telle sorte que
a) au moins un créneau temporel (ZS1 à ZS4) est préalablement occupé avec une valeur zéro (Z0) à une position fixe (AF), et
b) les créneaux temporels (ZS1 à ZS4) qui ne sont pas préalablement occupés comportent pour la formation d'une valeur logique (00, 01, 10, 11) d'un double bit (D1 à D4) au maximum un créneau temporel (ZS1 à ZS4) avec une valeur un (Z1).

2. Procédé selon la revendication 1, la trame à créneaux temporels (ZR1 à ZR4) d'un octet de données (BY1) étant suivie d'une trame de sécurité (SR) qui comporte un nombre de créneaux temporels (ZS1 à ZS4) correspondant à la trame à créneaux temporels (ZR1 à ZR4) précédente,
a) au moins un créneau temporel (ZS1 à ZS4) de la trame de sécurité (SR) étant occupé préalablement à la position correspondante (AF) de la trame à créneaux temporels (ZR1 à ZR4) par une valeur zéro (Z0), et
b) le codage dans la trame de sécurité (SR) s'effectuant de telle sorte qu'un premier nombre de valeurs un (AZ) déterminé à partir de la trame à créneaux temporels (ZR1 à ZR4) de l'octet de données (BY1) est codé dans les créneaux temporels non occupés préalablement (ZS1 à ZS4) de la trame de sécurité (SR) ayant au maximum deux valeurs un (Z1) non consécutives.

3. Procédé selon la revendication 2, les créneaux temporels (ZS1 à ZS4) de la trame de sécurité (SR) étant occupés de telle sorte que la dispersion de toutes les valeurs cumulées de valeur un (SZ1) dans la trame à créneaux temporels (ZR1 à ZR4) de l'octet de données (BY1) et dans la trame de sécurité (SR) est minimale.

4. Procédé selon l'une des revendications précédentes, la position (AF) du créneau temporel préalablement occupé (ZS1 à ZS4) se trouvant au début ou à la fin de la trame à créneaux temporels (ZR1 à ZR4) ou de la trame de sécurité (SR).

5. Procédé selon l'une des revendications précédentes, un créneau temporel (ZS1 à ZS4) avec une valeur un (Z1) étant formé par une séquence d'impulsions (PF).

6. Procédé selon la revendication 5, la séquence d'impulsions (PF) comportant un nombre pair d'impulsions (PL) et de pauses (PS) avec un taux d'impulsions identique.

7. Procédé selon la revendication 6, un nombre spécifiable d'oscillations de porteuse (fo) étant associé à une impulsion (PL).

8. Mémoire de données mobile (DT) pour l'échange sans contact d'une séquence d'octets de données (BY1, BY2) comprenant un appareil d'écriture / lecture (SLG), ayant un premier dispositif de codage (KE1) qui est conçu pour la mise en oeuvre du procédé selon l'une des revendications précédentes 1 à 7.

9. Mémoire de données mobile (DT) selon la revendication 8, le premier dispositif de codage (KE1) lors de la réception de deux créneaux temporels consécutifs (ZS1 à ZS4) avec une valeur un (Z1) occupant un créneau temporel (ZS1 à ZS4) à une position (AF) avec une valeur un (Z1).

10. Mémoire de données mobile (DT) selon la revendication 8, le premier dispositif de codage (KE1) déterminant un deuxième nombre de valeurs un (AZ1) à partir de la trame à créneaux temporels (ZR1 à ZR4) d'un octet de données (BY1) et comparant celui-ci à un premier nombre de valeurs un (AZ) codé auparavant dans une trame de sécurité (SR) et, en cas de résultat différent, occupant un créneau temporel (ZS1 à ZS4) de la trame de sécurité (SR) à une position (AF) avec une valeur un (Z1).

11. Mémoire de données mobile (DT) selon la revendication 8, comprenant des moyens d'interrogation (AM1) qui, lors de la détection d'une valeur un (Z1) à une position (AF) d'un créneau temporel préalablement occupé (ZS1 à ZS4), interrompent l'échange sans contact d'une séquence d'octets de données (BY1, BY2).

12. Mémoire de données mobile (DT) selon la revendication 11, qui, après une interruption, relance l'échange sans contact au moins à partir de la partie non échangée de la séquence d'octets de données (BY1, BY2).

13. Appareil d'écriture / lecture (SLG) pour l'échange sans contact d'une séquence d'octets de données (BY1, BY2) ayant au moins une mémoire de données mobile (DT), avec un deuxième dispositif de codage (KE2) qui est conçu pour la mise en oeuvre du procédé selon l'une des revendications précédentes 1 à 7.

14. Appareil d'écriture / lecture (SLG) selon la revendication 13, le deuxième dispositif de codage (KE2) lors de la réception de deux créneaux temporels consécutifs (ZS1 à ZS4) avec une valeur un (Z1) occupant un créneau temporel (ZS1 à ZS4) à une position (AF) avec une valeur un (Z1).

15. Appareil d'écriture / lecture (SLG) selon la revendication 13, le deuxième dispositif de codage (KE2) déterminant un troisième nombre de valeurs un (AZ2) à partir de la trame à créneaux temporels (ZR1 à ZR4) d'un octet de données (BY1) et comparant celui-ci à un premier nombre de valeurs un (AZ) codé auparavant dans une trame de sécurité (SR) et, en cas de résultat différent, occupant un créneau temporel (ZS1 à ZS4) de la trame de sécurité (SR) à une position (AF) avec une valeur un (Z1).

16. Appareil d'écriture / lecture (SLG) selon la revendication 13, avec des moyens d'interrogation (AM2) qui, lors de la détection d'une valeur un (Z1) à une position (AF) d'un créneau temporel préalablement occupé (ZS1 à ZS4), interrompent l'échange sans contact d'une séquence d'octets de données (BY1, BY2).

17. Appareil d'écriture / lecture (SLG) selon la revendication 16, qui, après une interruption, redémarre l'échange sans contact au moins à partir de la partie non échangée de la séquence d'octets de données (BY1, BY2).

18. Système d'identification (IS) avec des moyens pour la mise en oeuvre du procédé selon l'une des revendications 1 à 7, avec un procédé de modulation sur la base du standard ISO / IEC 14443 en vue d'une exploitation dans une bande de fréquences ISM.

19. Système d'identification (IS) avec des moyens pour la mise en oeuvre du procédé selon l'une des revendications 1 à 7, avec un procédé de modulation sur la base du standard ISO / IEC 15693 en vue d'une exploitation dans une bande de fréquences ISM.

20. Système d'identification (IS) selon la revendication 18 ou 19, qui est exploité dans une bande de fréquences ISM de 13,56 MHz.

21. Système d'identification (IS) comprenant au moins un appareil d'écriture / lecture (SLG) selon la revendication 13 ou 17 et ayant au moins une mémoire de données mobile (DT) selon l'une des revendications 8 à 12 qui échangent des séquences d'octets de données (BY1, BY2) par l'intermédiaire d'une voie de transmission de données sans contact (LS).
